# EUROPÄISCHE PATENTSCHRIFT

(11) **EP 1 785 708 B1**
(45) Veröffentlichungstag und Bekanntmachung des Hinweises auf die Patenterteilung: **03.01.2018**
(21) Anmeldenummer: 06400035.9
(22) Anmeldetag: 07.11.2006
(51) Int. Cl.: G01L 19/00, G01L 19/14, G01L 9/00

(54) **Drucksensor-Bauelement**
Pressure sensor component
Composant de capteur de pression

(30) Priorität: 09.11.2005 DE 102005053876; 09.11.2005 DE 102005053877; 09.11.2005 DE 202005017626 U; 09.11.2005 DE 202005017627 U
(43) Veröffentlichungstag der Anmeldung: 16.05.2007
(73) Patentinhaber: TDK-EPC AG & Co. KG, 14532 Stahnsdorf (DE); Harting AG, 2500 Biel 6 (CH)
(72) Erfinder: Bloch, Hartmut, 12307 Berlin (DE); Krause, Jens, Dr.-Ing., 32369 Rahden (DE)
(74) Vertreter: Epping - Hermann - Fischer

(56) Entgegenhaltungen:
- DE-A1- 19 626 084
- JP-A- 10 048 082
- JP-A- 10 098 059
- JP-A- 2003 130 742
- JP-A- 2003 130 743
- JP-A- 2003 130 749
- JP-A- 2003 133 453

## Beschreibung

Die Erfindung betrifft Drucksensor-Bauelemente.

Durch die Druckschriften DE 38 40 941 A1 (Druckwandler) und DE 102 16 020 A1 (Drucksensor und Gehäuse für Drucksensor) sind Gehäuse mit Drucksensoren und sowohl Druckanschlüssen als auch elektrischen Anschlüssen bekannt. Die elektrische Kontaktierung erfolgt drahtgebunden an entsprechend ausgebildete Kontaktklemmen. Der Sensor befindet sich in einem abgeschlossenen Gehäuse mit einem Anschluss für das Medium, dessen Druck erfasst werden soll. Diese Lösungen sind nur für eine Absolutdruckmessung geeignet.
Die Druckschrift DE 43 15 962 C2 (Kapsel für einen Drucksensor und Verfahren zur Einkapselung desselben) beinhaltet eine Kapsel für einen Drucksensor zum Schutz vor einem korrosiven Druckmedium. Dazu befindet sich der Drucksensor unter wenigstens einer Schutzmembran. Zwischen Schutzmembran und Drucksensor befindet sich ein Druckmittlermedium. Das zu messende Medium greift direkt an die Schutzmembran an. Die elektrische Kontaktierung erfolgt mit eingelagerten und nach außen führenden elektrischen Leitern. Für eine Montage auf einem Träger sind diese Kapseln nicht vorgesehen.
Die Lösungen in den Druckschriften DE 196 26 084 C2 (Drucksensorvorrichtung für eine Montage auf der Bestückungsoberfläche einer Leiterplatte) und DE 197 24 026 A1 (Drucksensor-Bauelement und Verfahren zur Herstellung) sind für eine Montage und Kontaktierung auf einer Leiterplatte als Träger geeignet. Die Kontaktierung erfolgt über den Chipträger, wobei Endenbereich des verwendeten Leadframe nach außen geführt sind und dort frei zugänglich enden. Der Sensor zur Druckmessung befindet sich im Inneren der jeweiligen Vorrichtung, wobei das zu messende Medium an einen Bereich der Vorrichtung angreift. Das Medium wirkt auf ein Gel zwischen Abdeckung und Drucksensor oder auf der Abdeckung des Drucksensors selbst. Dabei ist das Gel oder die Abdeckung ein Druckmittler zwischen Medium und Drucksensor. Diese Lösungen sind nur für eine Absolutdruckmessung geeignet. Die Druckschrift JP2003130749 offenbart eine Drucksensorvorrichtung mit einem wannenförmigen Gehäuseteil und einem Öffnung für ein Drucksensorelement in einer Trägerfläche. Der im Patentanspruch 1 angegebenen Erfindung liegt die Aufgabe zugrunde, ein einfach zu realisierendes, ökonomisch günstig herzustellendes, kompaktes und leicht handzuhabendes Bauelement als Drucksensor zu schaffen.

Diese Aufgabe wird mit den im Patentanspruch 1 aufgeführten Merkmalen gelöst.

Die Drucksensor-Bauelemente zeichnen sich insbesondere durch eine einfache und kompakte Realisierung bei universeller Einsatzmöglichkeit aus.
Ein erstes wannenförmiges Gehäuseteil als Träger von Leiterbahnen und des Drucksensorelementes ist vorteilhafterweise ein MID-Gehäuseteil (MID = molded interconnect device), so dass dieses Gehäuseteil selbst ein Schaltungsträger ist. Das erste Gehäuseteil besitzt wenigstens eine Trägerfläche, auf dem sich das wenigstens eine Drucksensorelement befindet. Vorteilhafterweise ist die Trägerfläche gleichzeitig ein Bestandteil des ersten Gehäuseteils.
Die ein Bestandteil des ersten Gehäuseteils darstellende Trägerfläche weist wenigstens eine Öffnung für das Drucksensorelement auf, wobei sich die Öffnung im Bodenbereich des ersten Gehäuseteils befindet. Mit einer derartigen Realisierung mit einem Drucksensorelement kann das Drucksensor-Bauelement leicht zur Absolutdruckmessung im Druck zu messenden Medium eingesetzt werden. Das zu messende Medium liegt über die Öffnung an dem Drucksensorelement an.
Die Verwendung eines MID-Gehäuses führt zu einem kompakten Drucksensor-Bauelement, das nur wenige Bestandteile aufweist. Das erste Gehäuseteil führt zu einer leichten Handhabbarkeit und Anschlussmöglichkeit des Drucksensorelementes.
Im ersten Gehäuseteil ist entweder ein zweites plattenförmiges Gehäuseteil oder ein Körper angeordnet, wobei die Wandung des ersten Gehäuseteils das zweite Gehäuseteil oder den Körper überragt und entweder auf der Randfläche der Wandung des ersten Gehäuseteils oder einen Wandbereich umfassende und damit auf einem Außenwandbereich des ersten Gehäuseteils endende Leiterbahnen gleichzeitig Anschlusskontakte sind. Die Endenbereiche sind dami vorteilhafterweise gleichzeitig die elektrischen Kontakte des Drucksensor-Bauelementes nach außen. Diese Endenbereiche und gegebenenfalls weitere vorhandene Endenbereiche von Leiterbahnen können leicht zur elektrischen Kontaktierung und/oder mechanischen Befestigung des Drucksensor-Bauelements zum Beispiel auf Bauelementeträgern genutzt werden, so dass das Drucksensor-Bauelement maschinell auf Bauelementeträger platziert und mit diesem kontaktiert werden kann.
Der Körper im ersten Gehäuseteil ist zum Beispiel eine Vergussmasse zum Schutz des Drucksensorelementes einschließlich dessen Kontaktierung im ersten Gehäuseteil.
Das Gehäuseteil als MID-Gehäuse zeichnet sich weiterhin dadurch aus, dass es als Kunststoffspritzteil leicht und ökonomisch auch in großen Stückzahlen als Massenprodukt herstellbar ist. Dieser Spritzgusskörper wird mit einer strukturierten Metallisierung mit Leiterbahnen versehen, so dass das Gehäuseteil selbst ein Schaltungsträger ist. Dazu wird der Spritzgusskörper mit einer bekannten Metallabscheidung beschichtet, wobei unterschiedliche Eigenschaften der verwendeten Kunststoffe eine selektive Metallisierung bewirken und das strukturierte Leiterbild entsteht. Damit kann das Drucksensor-Bauelement leicht auch als Massenprodukt hergestellt und bereitgestellt werden.
Durch den einfachen Aufbau eignet sich der derartige Aufbau sowohl für eine manuelle Kleinserienfertigung als auch für eine maschinelle Großserienfertigung. Im letzteren Fall kann auch eine Fertigungsstraße mit Bestückungsplätzen und Montageplätzen eingesetzt werden.

Vorteilhafte Ausgestaltungen der Erfindung sind in den Patentansprüchen 2 bis 11 angegeben.

Nach der Weiterbildung des Patentanspruchs 2 weist die ein Bestandteil des ersten Gehäuseteils darstellende Trägerfläche eine erste Öffnung für das Drucksensorelement und das erste Gehäuseteil mindestens eine zweite Öffnung neben der Trägerfläche auf, wobei sich die Öffnungen im Bodenbereich des ersten Gehäuseteils befinden. Weiterhin ist das zweite plattenförmige Gehäuseteil im ersten Gehäuseteil angeordnet, wobei die Wandung des ersten Gehäuseteils das zweite Gehäuseteil überragt, zwischen Drucksensorelement und zweitem Gehäuseteil wenigstens ein über die zweite Öffnung offener Hohlraum vorhanden ist und entweder auf der Randfläche der Wandung des ersten Gehäuseteils oder einen Wandbereich umfassende und damit auf einem Außenwandbereich des ersten Gehäuseteils endende Leiterbahnen gleichzeitig Anschlusskontakte sind.
Damit ist eine einfache und kompakte Realisierung bei universeller Einsatzmöglichkeit vorhanden. So sind diese vorteilhafterweise zur Absolut- und/oder Differenz- und/oder Relativdruckmessung geeignet.
Das erste Gehäuseteil ist mit einem zweiten plattenförmigen Gehäuseteil so versehen, dass das zweite Gehäuseteil beabstandet zu dem Drucksensorelement angeordnet ist. Mit einer derartigen Realisierung mit einem Drucksensorelement kann das Drucksensor-Bauelement vorteilhafterweise leicht entweder zur Absolutdruckmessung oder zur Differenzdruckmessung eingesetzt werden. Bei der ersten Variante ist das erste Gehäuseteil abgeschlossen, wobei das zu messende Medium über die Öffnung an dem Drucksensorelement anliegt. Bei der Differenzdruckmessung als zweite Variante wird das erste Gehäuseteil so mit dem zweiten Gehäuseteil versehen, dass zwei Medien an dem Drucksensorelement angreifen. Das erste Medium kann über die Öffnung auf eine Seite des Drucksensorelementes angreifen, während das zweite Medium über wenigstens eine Öffnung zum Beispiel als Aussparung oder Durchbruch des zweiten Gehäuseteils und den durch den Abstand vorhandene Hohlraum zwischen erstem Gehäuseteil und Drucksensorelement an die andere Seite des Drucksensorelementes gelangt. Dadurch kann eine Gehäuseausführung leicht für sehr unterschiedliche Anwendungen eingesetzt werden, so dass ein universeller Einsatz gegeben ist.

Die Leiterbahnen enden nach der Weiterbildung des Patentanspruchs 3 auf kammartigen Erhöhungen der Wandung des Gehäuseteils, so dass eine leichte maschinelle elektrische Kontaktierung in Form von Lotverbindungen des Drucksensor-Bauelements möglich ist. Die Erhöhungen führen vorteilhafterweise dazu, dass benachbarte Leiterbahnen bei dieser Kontaktierung nicht miteinander verbunden werden. Damit können die bekannten und technologisch ausgereiften Verfahren der SMT-Techniken (SMT = surface mounted technology) zur Montage, Befestigung und Kontaktierung des Drucksensor-Bauelementes zur Anwendung kommen.

Ein Anschlussfitting für die Öffnung oder mehrere Anschlussfittings für die Öffnungen nach der Weiterbildung des Patentanspruchs 4 gewährleistet oder gewährleisten eine leichte Handhabbarkeit des Drucksensor-Bauelements hinsichtlich des Anschlusses des Mediums. Eine Schlauchleitung kann leicht aufgeschoben werden, wobei auch wenigstens eine Befestigungsschelle für die Schlauchleitung angewandt werden kann. Ein Anschlussfitting gewährleistet einen festen und sicheren Halt der Schlauchleitung.

Das zweite Gehäuseteil ist nach der Weiterbildung des Patentanspruchs 5 ein Bauelementeträger mit Leiterbahnen und damit selbst ein Schaltungsträger. Dadurch sind spezielle und anwenderspezifische Schaltungsvarianten zur Auswertung der erfassten Messwerte realisierbar. Die Gehäuseteile können dabei leicht so ausgebildet sein, dass bei der Verbindung dieser Teile gleichzeitig entsprechend angeordnete Leiterbahnen miteinander elektrisch leitend zusammengeschaltet werden.

Wenigstens ein Bauelementeträger mit Leiterbahnen und wenigstens einem Chip mit einer integrierten Schaltung und/oder mindestens einem elektronischen Bauelement und damit ein Schaltungsträger ist nach der Weiterbildung des Patentanspruchs 6 zwischen dem Boden des ersten Gehäuseteils und dem zweiten Gehäuseteil angeordnet und mit Leiterbahnen von Wandbereichen des ersten Gehäuseteils verbunden. Damit ist ein Schichtaufbau gegeben, wodurch komplexe und umfangreiche Schaltungen im Drucksensor-Bauelement realisiert werden können. Die Bauelementeträger können anwenderspezifisch ausgebildet werden, wobei die unterschiedlichsten Schaltungsvarianten realisierbar sind.

Im ersten Gehäuseteil ist nach der Weiterbildung des Patentanspruchs 7 weiterhin wenigstens ein Chip mit einer integrierten Schaltung angeordnet und mit Leiterbahnen dieses Gehäuseteils verbunden. Die integrierte Schaltung ist vorteilhafterweise ein Datenverarbeitungssystem, so dass die Messdaten im Drucksensor-Bauelement aufbereitet werden können. Dadurch ist ein intelligentes Drucksensor-Bauelement realisiert. Ein derartiges Bauelement kann damit auch anwendungsspezifisch hergestellt werden. Dazu sind diese weiterhin nebeneinander entweder in einer Ebene oder in unterschiedlichen Ebenen im ersten Gehäuseteil angeordnet. Das führt zu einer leichten und ökonomischen Herstellung des Drucksensor-Bauelementes.
Dabei können sich die Oberflächen des Chip als Drucksensorelement und des Chip mit einer integrierten Schaltung vorteilhafterweise in einer Ebene befinden. Die Verbindung des jeweiligen Chip mit Leiterbahnen erfolgt vorzugsweise mittels gebondeter Drahtbrücken. Die gleiche Ebene führt zu gleichen technologischen Bearbeitungsbedingungen, so dass eine ökonomische Herstellung gegeben ist.
Damit ist ein intelligentes Drucksensor-Bauelement vorhanden. Durch einen spezifischen Einsatz von speziellen sowohl Drucksensorelementen als auch elektronischen Bauelementen und/oder Schaltungsträgern zum Beispiel als Chip mit einer integrierten Schaltung in Form einer Auswerteschaltung können leicht die unterschiedlichsten Anwendungen realisiert werden.

Nach der Weiterbildung des Patentanspruchs 8 befindet sich zwischen Drucksensorelement und zweitem Gehäuseteil ein Hohlraum, ein Körper, ein Medium oder ein Referenzvakuum. Der Hohlraum, der Körper, das Medium oder das Vakuum sind eine Referenz des Drucksensor-Bauelements. Der Körper befindet sich dazu im Hohlraum zwischen Drucksensorelement und zweitem Gehäuseteil.

Wenigstens ein Eckbereich von Wandungen des ersten Gehäuseteils des Drucksensor-Bauelements weist nach der Weiterbildung des Patentanspruchs 9 eine Erhöhung auf. Diese Erhöhung befindet sich auf aneinander grenzenden Wandungen und stellt vorteilhafterweise eine Montagehilfe und/oder eine mechanische Befestigungsmöglichkeit für das Drucksensor-Bauelement dar. Diese Erhöhung ist vorteilhafterweise ein Zapfen, ein Haken oder ein Teil mit einem Klemmmechanismus.

Das Drucksensorelement ist nach der Weiterbildung des Patentanspruchs 10 ein Chip mit einem abgedünnten Bereich als Membran auf einem Sockel. Die Membran weist wenigstens ein elektrisches bei Dehnung seinen elektrischen Widerstandswert ändernden Element auf. Der Sockel besitzt eine durchgehende Öffnung. Diese Öffnung und die Öffnung im ersten Gehäuseteil bewirken, dass das Medium an die Membran des Drucksensorelementes gelangen kann. Die Verwendung eines Sockels erleichtert die Handhabbarkeit des Drucksensorelementes. Weiterhin können auch unterschiedliche Querschnitte der Membran und der Öffnungen leicht realisiert werden. Der Querschnitt und die Dicke der Membran bestimmen die Empfindlichkeit des Drucksensorelementes. Das Element ist vorteilhafterweise ein Halbleiter-Messelement als integraler Bestandteil des Drucksensorelementes. Mit diesen Merkmalen ist das Drucksensor-Bauelement vorteilhafterweise für eine Absolut- und/oder eine Differenz- und/oder Relativdruckmessung geeignet.

Nach der Weiterbildung des Patentanspruchs 11 ist wenigstens der Bereich der Membran auf der dem anliegenden und zu messenden Medium gegenüberliegenden Seite mit einem haubenartigen Körper abgedeckt und der durch die Membran und dem Körper begrenzte Hohlraum weist ein Referenzvolumen auf. Eine derartige Realisierung eignet sich nur für eine Absolutdruckmessung. Vorteilhafterweise befindet sich ein Vakuum in diesem Hohlraum. Der haubenartige Körper schützt gleichzeitig wenigstens den druckempfindlichen Bereich des Drucksensorelementes gegenüber einem anliegenden Medium im Drucksensor-Bauelement. Dadurch ist insbesondere die Membran des Drucksensorelementes vom im Drucksensor-Bauelement sich befindenden Medium getrennt. Das Drucksensor-Bauelement zur Messung des Absolutdruckes kann besonders vorteilhaft zur Druckmessung unter schwierigen Medienbedingungen eingesetzt werden.

Ausführungsbeispiele der Erfindung sind in den Zeichnungen jeweils prinzipiell dargestellt und werden im folgenden näher beschrieben.
Es zeigen:
- Fig. 1: ein Drucksensor-Bauelement in einer Draufsicht,
- Fig. 2: das Drucksensor-Bauelement in einer Vorderansicht
- Fig. 3: ein Drucksensorelement für eine Differenz- und/oder Relativdruckmessung,
- Fig. 4: ein Drucksensorelement für eine Absolutdruckmessung,
- Fig. 5: ein Drucksensor-Bauelement mit zwei Öffnungen in einer Schnittdarstellung,
- Fig. 6: ein Drucksensor-Bauelement mit einem weiteren Bauelementeträger in einer Schnittdarstellung.

Ein Drucksensor-Bauelement eines ersten Ausführungsbeispiels besteht im Wesentlichen aus einem erstem wannenförmigen Gehäuseteil 1 mit Leiterbahnen 3 und einem Drucksensorelement 2.

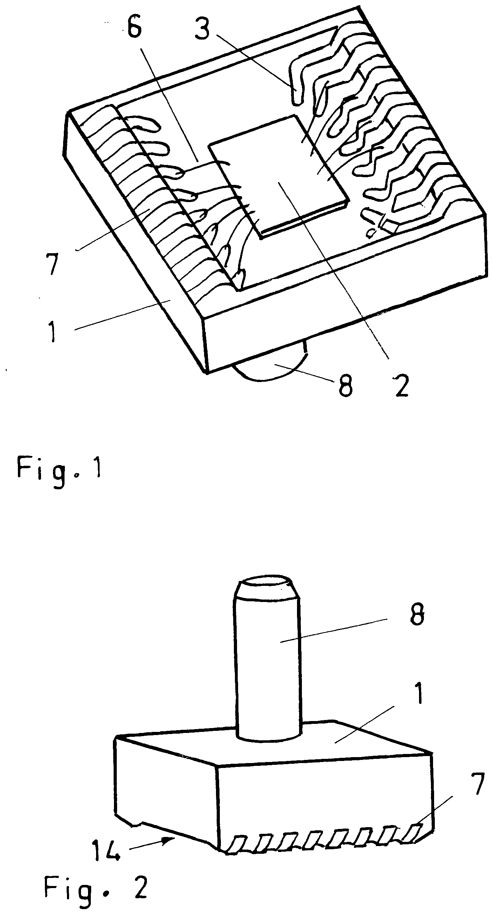

Die Fig. 1 zeigt das Drucksensor-Bauelement in einer Draufsicht.

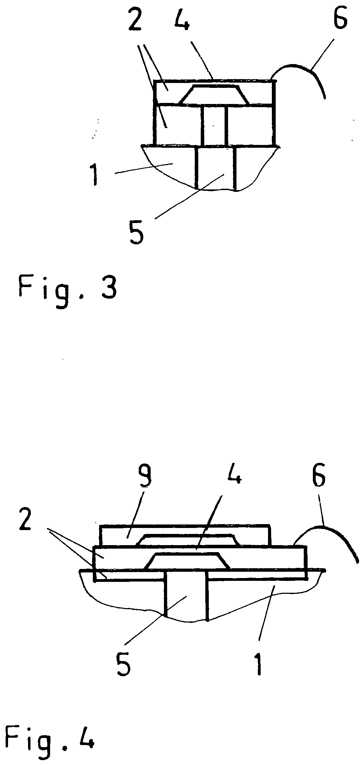

Das erste wannenförmige Gehäuseteil 1 ist ein spritzgegossenes Kunststoffteil mit sowohl auf-/eingebrachten Leiterbahnen 3 als auch einer Trägerfläche als MID-Gehäuseteil (MID = molded interconnect device). Auf der Trägerfläche befindet sich das mit Leiterbahnen 3 verbundene Drucksensorelement 2. Diese Trägerfläche ist Bestandteil des Bodenbereichs des Gehäuseteils 1 und weist eine Öffnung 5 für das Drucksensorelement 2 auf, so dass das Medium über die Öffnung 5 im Bodenbereich des Gehäuseteils 1 zum Drucksensorelement 2 gelangen kann (Darstellung in der Fig. 3). Die Öffnung 5 ist mit einem Anschlussfitting 8 versehen, der gleichzeitig ein Bestandteil des ersten Gehäuseteils 1 ist (Darstellung in der Fig. 2).
Das Drucksensorelement 2 ist ein Chip aus Silizium mit einem abgedünnten Bereich als Membran 4. Die Membran 4 ist mit wenigstens einem Element als Halbleiterelement in Form eines Halbleiterwiderstandes versehen, wobei bei Dehnung eine verhältnisgleiche elektrische Widerstandsänderung erfolgt. Das Element ist Bestandteil einer bekannten Messbrücke, wobei eine elektrische Widerstandsänderung zum Beispiel eine verhältnisgleiche elektrische Spannungsänderung hervorruft. Dazu ist das Element mit Kontakten des Chip als Drucksensorelement 2 elektrisch leitend verbunden. Der Chip als Drucksensorelement 2 befindet sich auf einem Sockel und/oder einem Podest, dessen Querschnitt gleich, kleiner oder größer als der des Chip als Drucksensorelement 2 ist. Der Sockel und/oder das Podest besitzt eine durchgehende Öffnung, wobei diese Öffnung und die Öffnung 5 des Gehäuseteils 1 einen Hohlraum umschließen. Die Querschnitte des abgedünnten Bereiches als Membran 4 ist größer (Darstellung in der Fig. 4), gleich oder kleiner als die der Öffnungen im Gehäuseteil 1 und entweder des Sockels und/oder Podestes.
Die Kontakte des Chip als Drucksensorelement 2 sind über gebondete Drahtbrücken 6 mit nach außen führende Leiterbahnen 3 als Anschlusskontakte 7 des Drucksensor-Bauelements verbunden. Dazu enden Leiterbahnen 3 auf der Randfläche der Wandung des ersten Gehäuseteils 1 oder umfassen dazu einen Wandbereich. Im letzteren Fall enden die Leiterbahnen 3 auf einem Außenwandbereich. Diese enden auf kammartigen Erhöhungen der Wandung des ersten Gehäuseteils 1. In einer Ausführungsform können diese auch als solche Erhöhungen selbst ausgebildet sein. Damit ist eine elektrische Kontaktierung des Drucksensor-Bauelements auf einer Leiterplatte mit Leiterbahnen leicht möglich. Diese Kontaktierungen und weitere können auch gleichzeitig die Befestigung des Drucksensor-Bauelements sein.
Für den Schutz des Drucksensorelementes 2 und der Drahtbrücken 6 befindet sich ein Körper, vorzugsweise als ausgehärtete Vergussmasse, oder ein zweites plattenförmiges Gehäuseteil 14 im ersten Gehäuseteil 1, wobei die Wandung des ersten Gehäuseteils 1 den Körper oder das zweite Gehäuseteil 14 überragt.

Ein Drucksensor-Bauelement besteht in einem zweitem Ausführungsbeispiel im Wesentlichen aus einem ersten wannenförmigen Gehäuseteil 1 als Schaltungsträger mit einem Drucksensorelement 2 und einem Chip 10 und/oder wenigstens einem elektronischen Bauelement und einem zweiten plattenförmigen Gehäuseteil 14.

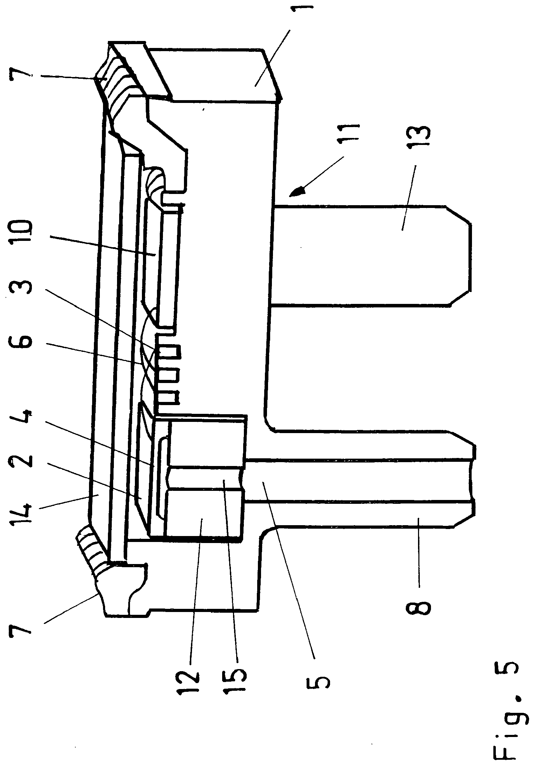

Die Fig. 5 zeigt das Drucksensor-Bauelement in einer Schnittdarstellung.

Das erste wannenförmige Gehäuseteil 1 ist ein spritzgegossenes Kunststoffteil mit sowohl auf-/eingebrachten Leiterbahnen 3 als auch Trägerflächen als MID-Gehäuseteil (MID = molded interconnect device). Auf der ersten Trägerfläche befindet sich das mit Leiterbahnen 3 verbundene Drucksensorelement 2. Diese Trägerfläche ist Bestandteil des Bodenbereichs des ersten Gehäuseteils 1 und weist eine erste Öffnung 5 für das Drucksensorelement 2 auf, so dass das Medium über die erste Öffnung 5 im Bodenbereich des ersten Gehäuseteils 1 zum Drucksensorelement 2 gelangen kann. Das erste Gehäuseteil 1 besitzt im Bodenbereich eine zweite Öffnung 11 neben den Trägerflächen für das Drucksensorelement 2 und den Chip 10 mit einer Auswerteelektronik. Die erste Öffnung 5 und die zweite Öffnung 11 sind mit Anschlussfittings 8, 13 versehen, die gleichzeitig ein Bestandteil des ersten Gehäuseteils 1 sind.
Das Drucksensorelement 2 ist ein Chip aus Silizium mit einem abgedünnten Bereich als Membran 4. Die Membran 4 ist mit wenigstens einem Element als Halbleiterelement in Form eines Halbleiterwiderstandes versehen, wobei bei Dehnung eine verhältnisgleiche elektrische Widerstandsänderung erfolgt. Das Element ist Bestandteil einer bekannten Messbrücke, wobei eine elektrische Widerstandsänderung zum Beispiel eine verhältnisgleiche elektrische Spannungsänderung hervorruft. Dazu ist das Element mit Kontakten des Chip als Drucksensorelement 2 elektrisch leitend verbunden. Der Chip als Drucksensorelement 2 befindet sich auf einem Sockel 3, dessen Querschnitt gleich oder kleiner als der des Chip als Drucksensorelement 2 ist. Der Sockel 12 kann entweder ein Körper sein oder aus mehreren miteinander verbundenen Körpern bestehen. In einer Ausführungsform kann die Trägerfläche die Oberfläche eines Podestes für das Drucksensorelement 2 sein, dass gleichzeitig ein Bestandteil des ersten Gehäuseteils 1 ist. Der Sockel 12 und/oder das Podest besitzt eine durchgehende Öffnung 15, wobei diese Öffnung 15 und die erste Öffnung 5 des ersten Gehäuseteils 1 einen Hohlraum umschließen. Die Querschnitte des abgedünnten Bereiches als Membran 4 ist größer (Darstellung in der Fig. 3), gleich oder kleiner als die der Öffnungen 5, 15.
Der Chip als Drucksensorelement 2 und der Chip 10 mit einer integrierten Schaltung sind nebeneinander im ersten Gehäuseteil 1 so angeordnet, dass sich die Oberflächen des Chip als Drucksensorelement 2 und des Chip 10 mit einer integrierten Schaltung in einer Ebene befinden (Darstellung in der Fig. 5). Gegebenenfalls können auch weitere elektronische Bauteile im ersten Gehäuseteil 1 platziert werden. Die Kontakte des Chip als Drucksensorelement 2 und des Chip 10 mit einer integrierten Schaltung sind je nach Schaltung über gebondete Drahtbrücken 6 und Leiterbahnen 3 miteinander und über gebondete Drahtbrücken 6 und nach außen führende Leiterbahnen 3 als Anschlusskontakte 7 des Drucksensor-Bauelementes verbunden. Für die letzte Variante enden Leiterbahnen 3 auf der Randfläche der Wandung des ersten Gehäuseteils 1. Diese Leiterbahnen 3 enden dazu auf kammartigen Erhöhungen der Wandung des ersten Gehäuseteils 1 oder sind über diese geführt, so dass diese auf einem Außenwandbereich enden. In einer Ausführungsform können diese auch als solche Erhöhungen selbst ausgebildet sein. Damit wird sichergestellt, dass diese Leiterbahnen 3 als Anschlusskontakte bei Platzierung des Drucksensor-Bauelementes auf einer Leiterplatte mit Leiterbahnen kontaktiert werden können. Diese Kontaktierungen können auch gleichzeitig die Befestigung des Drucksensor-Bauelementes sein. Nicht benötigte und/oder zusätzliche Anschlusskontakte können als weitere Befestigungen eingesetzt werden. Das erste Gehäuseteil 1 ist mit einem zweiten plattenförmigen Gehäuseteil 14 so abgeschlossen, dass das zweite Gehäuseteil 14 beabstandet zu dem Drucksensorelement 2 angeordnet ist und damit wenigstens ein über die zweite Öffnung 11 offener Hohlraum vorhanden ist.

In einer Ausführungsform des ersten Ausführungsbeispiels kann wenigstens der Bereich der Membran 4 auf der dem anliegenden und zu messenden Medium gegenüberliegenden Seite mit einem haubenartigen Körper 9 vorzugsweise als Glaskörper abgedeckt sein. Der durch die Membran 4 und diesem Körper 9 begrenzte Hohlraum weist ein Referenzvolumen insbesondere mit einem Referenzvakuum auf (Darstellung in der Fig. 4). Damit ist ein Drucksensor-Bauelement zur Absolutdruckmessung realisiert.

Ein Drucksensor-Bauelement zur Absolut- und/oder Differenz- und/oder Relativdruckmessung besteht in einem drittem Ausführungsbeispiel im Wesentlichen aus einem ersten wannenförmigen Gehäuseteil 1 mit einem Drucksensorelement 2 und einem zweiten plattenförmigen Gehäuseteil 14 als Schaltungsträger mit wenigstens einem Chip 10 zum Beispiel als elektronische Auswerteschaltung und/oder mindestens einem elektronischen Bauelement.

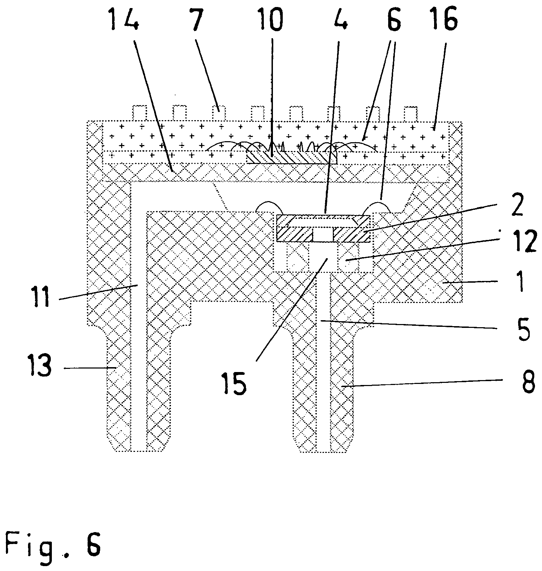

Die Fig. 6 zeigt das Drucksensor-Bauelement in einer Schnittdarstellung.

Das erste wannenförmige Gehäuseteil 1 ist ein spritzgegossenes Kunststoffteil mit sowohl auf-/eingebrachten Leiterbahnen 3 als auch einer Trägerfläche als MID-Gehäuseteil (MID = molded interconnect device). Auf der Trägerfläche befindet sich das mit Leiterbahnen 3 über gebondete Drahtbrücken 6 verbundene Drucksensorelement 2. Diese Trägerfläche ist gleichzeitig ein Bestandteil des Bodenbereiches des ersten Gehäuseteils 1 und weist eine erste Öffnung 5 für das Drucksensorelement 2 auf, so dass das Medium über diese erste Öffnung 5 zum Drucksensorelement 2 gelangen kann. Das erste Gehäuseteil 1 besitzt im Bodenbereich eine zweite Öffnung 11 neben der Trägerfläche für das Drucksensorelement 2. Die erste Öffnung 5 und die zweite Öffnung 11 sind mit Anschlussfittings 8, 13 versehen, die gleichzeitig ein Bestandteil des ersten Gehäuseteils 1 sind.
Das Drucksensorelement 2 ist ein Chip aus Silizium mit einem abgedünnten Bereich als Membran 4 mit wenigstens einem Element als Halbleiterelement auf einem Sockel 3 entsprechend dem des ersten Ausführungsbeispiels.
In einer ersten Ausführungsform des dritten Ausführungsbeispiels sind Leiterbahnen des ersten Gehäuseteils 1 nach außen geführt. Die Endenbereiche sind gleichzeitig als Anschlusskontakte 7 dieses Drucksensor-Bauelementes ausgebildet. Das erste Gehäuseteil 1 ist mit einem zweiten plattenförmigen Gehäuseteil 14 so abgeschlossen, dass das zweite Gehäuseteil 14 beabstandet zu dem Drucksensorelement 2 angeordnet ist und wenigstens ein über die zweite Öffnung 11 offener Hohlraum vorhanden ist. Damit ist ein Drucksensor-Bauelement zur Absolut- und/oder Differenz- und/oder Relativdruckmessung realisiert.
In einer zweiten Ausführungsform des dritten Ausführungsbeispiels sind Leiterbahnen zu den Endenbereichen des ersten Gehäuseteils 1 geführt. Das erste Gehäuseteil 1 ist mit einem zweiten plattenförmigen Gehäuseteil 14 so abgeschlossen, dass zwischen Drucksensorelement 2 und zweitem Gehäuseteil 14 wenigstens ein über die zweite Öffnung 11 offener Hohlraum vorhanden ist. Das zweite Gehäuseteil 14 ist als Schaltungsträger ausgebildet. Dazu ist wenigstens ein Chip 10 mit einer integrierten Schaltung und/oder mindestens ein elektronisches Bauelement und Leiterbahnen auf dem zweiten Gehäuseteil 14 angeordnet. Leiterbahnen des zweiten Gehäuseteils 14 sind über Randbereiche mit Leiterbahnen des ersten Gehäuseteils 1 verbunden. Weitere Leiterbahnen enden auf dem zweiten Gehäuseteil 14. Endenbereiche sind gleichzeitig als Kontakte 7 für das Drucksensor-Bauelement ausgebildet. Der Chip 10 mit einer integrierten Schaltung, die Leiterbahnen auf dem zweiten Gehäuseteil 14 und die gebondeten Drahtbrücken 6 zur elektrischen Verbindung der Leiterbahnen mit der integrierten Schaltung des Chip 10 und/oder des wenigstens einen elektronischen Bauelementes sind in einer Vergussmasse 16 eingebettet. Ein derartiges Drucksensor-Bauelement zeigt die Fig. 6.

In einer weiteren Ausführungsform der Ausführungsbeispiele kann wenigstens der Bereich der Membran 4 auf der dem anliegenden und zu messenden Medium gegenüberliegenden Seite mit einem haubenartigen Körper 9 insbesondere als Glaskörper abgedeckt sein. Der durch die Membran 4 und diesem Körper 9 begrenzte Hohlraum weist ein Referenzvolumen vorteil-hafterweise mit einem Referenzvakuum auf (Darstellung in der Fig. 4). Damit ist ein Druck-sensor-Bauelement zur Absolutdruckmessung realisiert.

Der Chip 10 als Auswerteelektronik und/oder der Chip als Drucksensorelement 2 können in weiteren Ausführungsformen der Ausführungsbeispiele auch mit anderen bekannten Verbindungstechnologien wie zum Beispiel der TAB-Technik (TAB = tape automated Bonding) mit Leiterbahnen der Gehäuseteile 1, 14 verbunden sein.

In weiteren Ausführungsformen der Ausführungsbeispiele kann sich zwischen Drucksensorelement 2 und zweitem Gehäuseteil 14 ein Körper, ein Medium oder ein Referenzvakuum befinden. Das Medium kann vorteilhafterweise ein Gel sein und der Körper aus einem elastischen Material bestehen.

In weiteren Ausführungsformen der Ausführungsbeispiele kann wenigstens ein Eckbereich von Wandungen des ersten Gehäuseteils 1 des Drucksensor-Bauelementes eine Erhöhung aufweisen. Diese Erhöhung befindet sich auf aneinander grenzenden Wandungen und stellt vorteilhafterweise eine Montagehilfe und/oder eine mechanische Befestigungsmöglichkeit für das Drucksensor-Bauelement dar. Vorteilhafterweise ist diese Erhöhung ein Zapfen, ein Haken oder ein Teil mit einem Klemmmechanismus. Diese Erhöhung kann damit leicht in eine Öffnung eines Trägers für das Drucksensor-Bauelement eingeführt und befestigt werden. Dazu ist die Erhöhung zum Beispiel ein konischer Zapfen mit wenigstens einer umlaufenden Vertiefung und/oder Erhöhung, so dass in Verbindung mit der Öffnung und des Trägers des Drucksensor-Bauelementes ein Schnappmechanismus realisiert ist.

## Patentansprüche

1. Drucksensor-Bauelement zur Differenzdruckmessung mit folgenden Merkmalen:
- einem ersten wannenförmigen Gehäuseteil (1) als spritzgegossenes Kunststoffteil mit sowohl Leiterbahnen (3) als MID-Gehäuseteil (MID = molded interconnect device) als auch im Innern wenigstens einer Trägerfläche,
- einem mit Leiterbahnen (3) verbundenem Drucksensorelement (2) als ein Chip mit einem abgedünnten Bereich als Membran (4) auf einem Sockel (12) auf der Trägerfläche, wobei die Membran (4) wenigstens ein bei Dehnung seinen elektrischen Widerstandswert änderndes Element aufweist und das Element mit Kontakten des Chip als Drucksensorelement (2) elektrisch leitend verbunden ist und der Querschnitt und die Dicke der Membran die Empfindlichkeit des Drucksensor
Bauelements bestimmen,
- einer ersten Öffnung (5) für das Drucksensorelement (2) in der Trägerfläche als ein Bestandteil des ersten Gehäuseteils (1) in Verbindung mit einer durchgehenden Öffnung (15) im Sockel (12), wobei die Querschnitte der Membran (4) und der Öffnungen (5, 15) gleich oder unterschiedlich sind,
- mindestens einer zweiten Öffnung (11) im ersten Gehäuseteil (1) neben der Trägerfläche, wobei sich die Öffnungen (5, 11) im Bodenbereich des ersten Gehäuseteils (1) befinden,
- einem zweitem plattenformigen Gehäuseteil (14) im ersten Gehäuseteil (1), wobei die Wandung des ersten Gehäuseteils (1) das zweite Gehäuseteil (14) überragt, zwischen Drucksensorelement (2) und zweitem Gehäuseteil (14) wenigstens ein über die zweite Öffnung (11) offener Hohlraum vorhanden ist, und
- auf kammartigen Erhöhungen der Wandung des ersten Gehäuseteils (1) endenden Leiterbahnen (3) als gleichzeitige Anschlusskontakte (7), Befestigungen oder Anschlusskontakte (7) und Befestigungen.

2. Drucksensor-Bauelement nach Patentanspruch 1, **dadurch gekennzeichnet, dass** das erste Gehäuseteil (1) Anschlussfittings (8, 13) für die erste Öffnung (5) und die zweite Öffnung (11) besitzt.

3. Drucksensor-Bauelement nach Patentanspruch 1, **dadurch gekennzeichnet, dass** das zweite Gehäuseteil (14) ein Bauelementeträger mit Leiterbahnen und wenigstens einem Chip (10) mit einer integrierten Schaltung und/oder mindestens einem elektronischen Bauelement und damit ein Schaltungsträger ist.

4. Drucksensor-Bauelement nach Patentanspruch 1, **dadurch gekennzeichnet, dass** wenigstens ein Bauelementeträger mit Leiterbahnen und wenigstens einem Chip (10) mit einer integrierten Schaltung und/oder mindestens einem elektronischen Bauelement und damit ein Schaltungsträger zwischen dem Boden des ersten Gehäuseteils (1) und dem zweiten Gehäuseteil (14) angeordnet und mit Leiterbahnen von Wandbereichen des ersten Gehäuseteils (1) verbunden ist.

5. Drucksensor-Bauelement nach Patentanspruch 1, **dadurch gekennzeichnet, dass** wenigstens ein Chip (10) mit einer integrierten Schaltung im ersten Gehäuseteil (1) angeordnet und mit Leiterbahnen (3) verbunden ist, wobei der Chip als Drucksensorelement (2) und der Chip (10) mit einer integrierten Schaltung nebeneinander entweder in einer Ebene oder in unterschiedlichen Ebenen im ersten Gehäuseteil (1) angeordnet sind.

6. Drucksensor-Bauelement nach Patentanspruch 1, **dadurch gekennzeichnet, dass** wenigstens ein Eckbereich von Wandungen des ersten Gehäuseteils (1) eine Erhöhung aufweist, wobei die Erhöhung ein Zapfen, ein Haken oder ein Teil mit einem Klemmmechanismus ist.

## Claims

1. Pressure sensor component for measuring
differential pressure, comprising the following features:
- a first tub-shaped housing part (1) as spray-cast plastic part having both conductor tracks (3) as MID (moulded interconnect device) housing part and in the interior at least one support area,
- a pressure sensor element (2), connected to conductor tracks (3), as a chip having a thinned area as membrane (4) on a base (12) on the support area, the membrane (4) having at least one element changing its electrical resistance value in the case of an expansion and the element being connected electrically conductively to contacts of the chip as pressure sensor element (2) and the cross section and the thickness of the membrane determining the sensitivity of the pressure sensor component,
- a first opening (5) for the pressure sensor element (2) in the support area as a component of the first housing part (1) in connection with a continuous opening (15) in the base (12), the cross sections of the membrane (4) and of the openings (5, 15) being identical or different,
- at least one second opening (11) in the first housing part (1) next to the support area, the openings (5, 11) being located in the bottom area of the first housing part (1),
- a second plate-shaped housing part (14) in the first housing part (1), the wall of the first housing part (1) protruding over the second housing part (14), between pressure sensor element (2) and second housing part (14), at least one hollow space open over the second opening (11) being present, and
- conductor tracks (3) ending on comb-like raised parts of the wall of the first housing part (1) as simultaneous connecting contacts (7), attachments or connecting contacts (7) and attachments.

2. Pressure sensor component according to Patent Claim 1, **characterized in that** the first housing part (1)
has connection fittings (8, 13) for the first opening (5) and the second opening (11).

3. Pressure sensor component according to Patent Claim 1, **characterized in that** the second housing part (14) is a component carrier with conductor tracks and at least one chip (10) having an integrated circuit and/or at least one electronic component and is thus a circuit carrier.

4. Pressure sensor component according to Patent Claim 1, **characterized in that** at least one component carrier having conductor tracks and at least one chip (10) with an integrated circuit and/or at least one electronic component and thus a circuit carrier is arranged between the bottom of the first housing part (1) and the second housing part (14) and connected to conductor tracks of wall areas of the first housing part (1).

5. Pressure sensor component according to Patent Claim 1, **characterized in that** at least one chip (10) with an integrated circuit is arranged in the first housing part (1) and connected to conductor tracks (3), the chip as pressure sensor element (2) and the chip (10) with an integrated circuit being arranged next to one another either in one plane or in different planes in the first housing part (1).

6. Pressure sensor component according to Patent Claim 1, **characterized in that** at least one corner area of walls of the first housing part (1) has a raised part, the raised part being a cone, a hook or a part having a clamping mechanism.

## Revendications

1. Élément structurel à capteur de pression destiné à la mesure de la pression différentielle comprenant les propriétés suivantes :
- une première partie de boîtier (1) en forme de cuve qui se présente sous la forme d'une partie en plastique moulée par injection, comprenant aussi bien des pistes conductrices (3), qui se présentent sous la forme d'une partie de boîtier MID (MID = molded interconnect device), que tout au moins une surface de support à l'intérieur ;
- un élément à capteur de pression (2) qui est relié aux pistes conductrices (3) et qui se présente sous la forme d'une puce avec une zone amincie qui se présente sous la forme d'une membrane (4) située sur un socle (12) se trouvant sur la surface de support, la membrane (4) présentant tout au moins un élément qui modifie sa résistance électrique en cas de dilatation et l'élément étant relié de manière électriquement conductrice à des contacts de la puce, sous la forme d'un élément à capteur de pression (2), et la section transversale et l'épaisseur de la membrane déterminant la sensibilité de l'élément structurel à capteur de pression ;
- une première ouverture (5) pour l'élément à capteur de pression (2) se trouvant dans la surface de support, sous la forme d'un élément constitutif de la première partie de boîtier (1) qui se trouve en liaison avec une ouverture (15) traversante dans le socle (12), les sections transversales de la membrane (4) et des ouvertures (5, 15) étant identiques ou différentes ;
- au moins une deuxième ouverture (11) située dans la première partie de boîtier (1), à côté de la surface de support, les ouvertures (5, 11) se trouvant au niveau du fond de la première partie de boîtier (1) ;
- une deuxième partie de boîtier (14), en forme de plaque, située dans la première partie de boîtier (1), la paroi de la première partie de boîtier (1) dépassant la deuxième partie de boîtier (14), tout au moins une cavité ouverte par l'intermédiaire de la deuxième ouverture (11) étant présente entre l'élément à capteur de pression (2) et la deuxième partie de boîtier (14) ; et
- des pistes conductrices (3), qui se présentent sous la forme de contacts de connexion (7) simultanés, de fixations ou sous la forme de contacts de connexion (7) et de fixations et qui se terminent sur des élévations de la paroi de la première partie de boîtier (1), lesquelles élévations ont la forme d'un peigne.

2. Élément structurel à capteur de pression selon la revendication de brevet 1, **caractérisé en ce que** la première partie de boîtier (1) possède des raccords de branchement (8, 13) pour la première ouverture (5) et pour la deuxième ouverture (11).

3. Élément structurel à capteur de pression selon la revendication de brevet 1, **caractérisé en ce que** la deuxième partie de boîtier (14) est un support pour élément structurel qui comprend des pistes conductrices et tout au moins une puce (10) dotée d'un circuit intégré et/ou qui comprend au moins un élément structurel électronique et, par conséquent, un support de circuit.

4. Élément structurel à capteur de pression selon la revendication de brevet 1, **caractérisé en ce que** tout au moins un élément de support pour élément structurel qui comprend des pistes conductrices et tout au moins une puce (10) comportant un circuit intégré et/ou qui comprend au moins un élément structurel électronique et, par conséquent, un support de circuit est disposé entre le fond de la première partie de boîtier (1) et la deuxième partie de boîtier (14) et est relié à des pistes conductrices des surfaces de paroi de la première partie de boîtier (1).

5. Élément structurel à capteur de pression selon la revendication de brevet 1, **caractérisé en ce que** tout au moins une puce (10) qui comprend un circuit intégré est disposée dans la première partie de boîtier (1) et est reliée à des pistes conductrices (3), la puce qui se présente sous la forme d'un élément à capteur de pression (2) et la puce (10) comportant un circuit intégré étant disposées l'une à côté de l'autre dans la première partie de boîtier (1), soit au même niveau, soit à des niveaux différents.

6. Élément structurel à capteur de pression selon la revendication de brevet 1, **caractérisé en ce que** tout au moins une zone de coin des parois de la première partie de boîtier (1) présente une élévation, l'élévation étant un tenon, un crochet ou une pièce comprenant un mécanisme de serrage.
